Europäisches Patentamt

European Patent Office

Office européen des brevets

(11) Publication number: **0 034 931**
**B1**

# EUROPEAN PATENT SPECIFICATION

(45) Date of publication of patent specification: **21.11.84**

(21) Application number: **81300720.0**

(22) Date of filing: **20.02.81**

(51) Int. Cl.³: **H 01 L 27/02, G 11 C 11/34**

(54) Semiconductor integrated circuit.

(30) Priority: **22.02.80 JP 21203/80**
**27.06.80 JP 87335/80**

(43) Date of publication of application:
**02.09.81 Bulletin 81/35**

(45) Publication of the grant of the patent:
**21.11.84 Bulletin 84/47**

(84) Designated Contracting States:
**DE FR GB**

(56) References cited:
**DE-A-2 751 591**
**GB-A-2 011 706**

(73) Proprietor: **Kabushiki Kaisha Toshiba**
**72, Horikawa-cho Saiwai-ku**
**Kawasaki-shi Kanagawa-ken 210 (JP)**

(72) Inventor: **Ariizumi, Shoji**
**1-11-10-202, Tamazutsumi Setagaya-ku**
**Tokyo (JP)**
Inventor: **Segawa, Makoto**
**1020, Hiyoshihoncho**
**Kouhoku-ku Yokohama-shi (JP)**
Inventor: **Maiwa, Hisaaki**
**Komamura-so, 15-17 Komukai**
**Saiwai-ku Kawasaki-shi (JP)**
Inventor: **Okamura, Seishi**
**442-58, Kamishirane**
**Asahi-ku Yokohama-shi (JP)**

(74) Representative: **Kirk, Geoffrey Thomas et al**
**BATCHELLOR, KIRK & EYLES 2 Pear Tree Court**
**Farringdon Road**
**London EC1R 0DS (GB)**

EP 0 034 931 B1

## Description

This invention relates to semiconductor integrated circuits in which steps are taken to reduce the adverse influences of minority carriers.

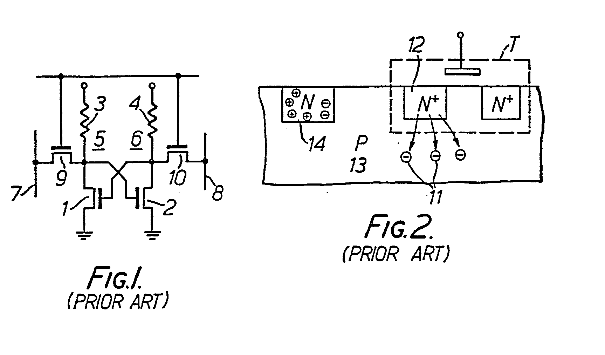

Recently, semiconductor technology for manufacturing integrated circuits has advanced in that storage capacity of one-chip memory has been substantially enlarged. Figure 1 illustrates a known N-type channel MOS static random access memory (RAM): This memory is composed of a flip-flop circuit constructed of a pair of inverter circuits 5 and 6 and a pair of transmitting transistors 9 and 10 connected to data lines 7 and 8 respectively. Inverter circuits 5 and 6 have driving transistors 1 and 2 and load resistors 3 and 4. Load resistors 3 and 4 are preferably made from high resistance polycrystalline silicon. This type of RAM is called a four transistor and two resistor RAM. The values of load resistors 3 and 4 are determined by ion implantation in which the impurity is injected into the undoped polycrystalline silicon layer. The resistors 3 and 4 have a negative gradient characteristic with change of temperature so that the resistance becomes lower at high temperatures, increasing the leakage current of the PN junction and the current supply.

Load resistors 3 and 4 are ordinarily in the range several $M\Omega$ to several hundred $M\Omega$ at high temperatures. However the value of load resistors 3 and 4 increases considerably into the G (1000 $M\Omega$) range at low temperatures. When the RAM is operated at low temperature, the leakage current of the PN junction decreases, and the leakage current decreases at a rate much greater than the rate of resistance increase. For example, when the temperature is lowered from 100°C to 25°C, the leakage current decreases by an order of magnitude of 3 to 4, but the value of the resistors increases no more than by a factor of two. Consequently, load resistors 3 and 4 have sufficiently performed to retain the data.

However, when the value of load resistors 3 and 4 becomes extremely high, these resistors are apt to be affected by the minority carriers produced by peripheral circuits other than the memory. In addition, the lower the temperature, the longer the lifetime of the minority carriers so that their influence on the memory is stronger. Figure 2 illustrates the effect of the minority carriers on a RAM composed of N-type channel transistors. Transistor T (shown by dotted line) forms part of a peripheral circuit, for example, an input circuit or a self-substrate biasing circuit. Minority carriers (electrons) 11 generated at N+ region 12 diffuse into P-type substrate 13 and reach another N+-type region 14 which is a part of the memory stored "1" level. Minority carriers 11 recombine with holes in N+-type region 14, thereby the "1" level loses some of the carriers. In the worst case, the "1" level is broken by the minority carriers. This phenomenon is apt to occur at low temperatures where resistors 3 and 4 have high values. Therefore, it is desirable to reduce the value of resistors 3 and 4 to prevent the outbreak of this phenomenon. However, if the value of the resistors of the memory is lowered, the electric power consumed by the RAM is increased.

An object of this invention is to provide an improved semiconductor integrated circuit with decreased electric power consumption and with established high density integration.

According to the present invention, a semiconductor integrated circuit includes a plurality of memory cells and at least one peripheral circuit which, in use, generates minority carriers, each of said memory cells being in the form of a flip-flop circuit having first and second MOS transistors and resistive means connected to the transistors and serving to store data; at least one, but not all, of the memory cells being positioned relative to the peripheral circuit such that the resistive means of the cell are likely to be influenced by the minority carriers, characterised in that the resistive means of the or each cell which are likely to be influenced by the minority carriers are of a lower value than the resistive means of those cells which are not so influenced such that data stored in said resistive means is not lost.

In order that the invention may be more readily understood, it will now be described, by way of example only, with reference to the accompanying drawings, in which:—

Figure 1 is a circuit diagram of a prior art semiconductor memory;

Figure 2 is a diagrammatic sectional view of a prior art semiconductor memory illustrating the effect of minority carriers; and

Figure 3 is a schematic plan view of an embodiment of this invention.

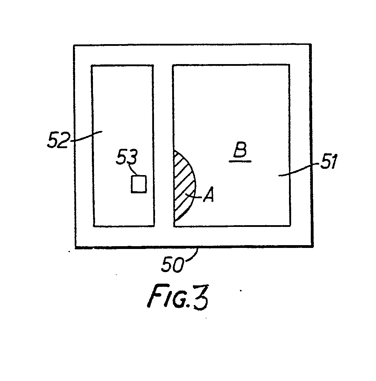

Figure 3 illustrates a schematic plan view of a memory having memory cells of the type shown in Figure 1. Chip 50 is composed of part 51 containing the memory and part 52 containing peripheral circuits including circuit 53 which generates minority carriers, for example an input circuit, a self-substrate biasing circuit, etc. Since a region A of part 51 is close to part 53, the minority carriers from part 53 can reach region A. Now, the values of the resistors 3 and 4 of the part of the memory in region A are equal and set to $R_1$. A region B is located further from part 53 than is region A and the minority carriers do not reach, or at least do not have any influence in, region B. The values of resistors 3 and 4 (shown in Figure 1) of the memories in region B are equal and set to $R_2$, and a relation $R_1$ to $R_2$ is established between the resistors of the regions A and B.

The value of the resistors serving as the load elements in region A is arranged to be lower than in region B and so the destruction of data is prevented. Moreover, use of polycrystalline silicon as the load elements harms high integration. This improvement is accompanied by only a little increase of electric power consumption since region A is much smaller than region B. When the memory has a capacity of 1 K bits or 2 K bits, the area of region A is about one-tenth of the total area, for a 64 K or 28 K bit memory the ratio is one to several hundreds.

One method of reducing the value of resistors 3 and 4 in region A is additional ion implanting using a photo engraving process (PEP) only in region A when the value of the resistors is determined by the quantity of the impurity of ion implantation. If the value of the resistors is determined by the length of polycrystalline silicon layer not including the impurity, a better method is selective ion implantation only in region A. The values can also be varied by designing the pattern of the resistors.

Many changes and modifications can, of course, be carried out without departing from the scope of the present invention, that scope, accordingly, being defined only by the scope of the appended claims.

## Claims

1. A semiconductor integrated circuit including a plurality of memory cells (14) and at least one peripheral circuit (12) which, in use, generates minority carriers, each of said memory cells being in the form of a flip-flop circuit having first and second MOS transistors (1, 2) and resistive means (3, 4) connected to the transistors and serving to store data; at least one, but not all, of the memory cells being positioned relative to the peripheral circuit such that the resistive means (3, 4) of the cell are likely to be influenced by the minority carriers, characterised in that the resistive means of the or each cell which are likely to be influenced by the minority carriers are of a lower value than the resistive means of those cells which are not so influenced such that data stored in said resistive means is not lost.

2. A semiconductor integrated circuit as claimed in claim 1, characterised in that the elements providing resistance are formed by doped polycrystalline silicon.

## Patentansprüche

1. Integrierte Halbleiterschaltung bestehend aus mehreren Speicherzellen (14) und mindestens einer peripheren Schaltung (12), die, wenn sie arbeitet und im Betriebszustand ist, Minoritätsträger erzeugt. Jede der vorerwähnten Speicherzellen ist als Flip-Flop-Schaltung ausgeführt, und besteht aus einem ersten und einem zweiten Metalloxid-Silizium-Transistor/MOS-Transistor (1, 2) sowie aus den schaltungsmäßig mit den Transistoren verbundenen Widerstandsvorrichtungen (3, 4) zum Speichern der Daten. Mindestens eine der Speicherzellen — jedoch nicht alle Speicherzellen — ist im Hinblick auf die periphere Schaltung (12) derart angeordnet, daß die Widerstandsvorrichtungen (3, 4) der Speicherzelle wahrscheinlich von den Minoritätsträgern beeinflußt werden, dadurch gekennzeichnet, daß die Widerstandsvorrichtungen der Zelle oder einer jeden Zelle, die von den Minoritätsträgern beeinflußt wird/werden, einen geringeren Widerstandswert haben als die Widerstandsvorrichtungen der Speicherzellen, die von den Minoritätsträgern nicht beeinflußt werden, so daß die in diesen Widerstandsvorrichtungen gespeicherten Daten nicht verloren werden lönnen.

2. Integrierte Halbleiterschaltung nach Anspruch 1, dadurch gekennzeichnet, daß die Schaltungselemente, die den Widerstand hervorbringen aus gedopten oder dotierten polykristallinen Silizium hergestellt werden.

## Revendications

1. Circuit semi-conducteur intégré incluant un certain nombre de cellules de mémoire (14) et, au moins, un circuit périphérique (12) qui, pendant le fonctionnement, génère des porteurs minoritaires, chacune desdites cellules de mémoire se présentant sous la forme d'un circuit bascule ayant un premier et un second transistors MOS (1, 2) et des éléments à résistance (3, 4) connectés aux transistors et servant à conserver des données; l'une, au moins, mais pas toutes, les cellules de la mémoire étant placées par rapport au circuit périphérique de façon que les éléments à résistance (3, 4) de la cellule sont susceptibles d'être influencés par les porteurs électrisés minoritaires, caractérisé en ce que les éléments à résistance de la ou de chaque cellule qui sont susceptibles d'être influencés par les porteurs électrisés minoritaires ont une valeur plus basse que les éléments à résistance des cellules qui ne sont pas ainsi influencées, de sorte que les données conservées dans lesdits éléments à résistance ne sont pas perdues.

2. Circuit semi-conducteur intégré selon la revendication 1, caractérisé en ce que les éléments produisant la résistance sont formés par un silicium polycristallin dopé.

FIG.1.
(PRIOR ART)

FIG.2.
(PRIOR ART)

FIG.3